Europäisches Patentamt

European Patent Office

Office européen des brevets

(19)

(11) Publication number: **0 019 003**
**B1**

# (12) EUROPEAN PATENT SPECIFICATION

(45) Date of publication of patent specification: **23.11.83**

(51) Int. Cl.³: **H 01 S 3/18, H 01 L 21/58**

(21) Application number: **79901610.0**

(22) Date of filing: **28.11.79**

(86) International application number:
**PCT/JP79/00302**

(87) International publication number:
**WO 80/01222 12.06.80 Gazette 80/13**

(54) **METHOD OF MANUFACTURING SEMICONDUCTOR LASER DEVICES.**

(30) Priority: **01.12.78 JP 148839/78**

(43) Date of publication of application:
**26.11.80 Bulletin 80/24**

(45) Publication of the grant of the patent:
**23.11.83 Bulletin 83/47**

(84) Designated Contracting States:
**DE FR GB NL**

(56) References cited:
**GB - A - 1 079 033**
**GB - A - 1 426 539**
**JP - A - 50 043 895**
**JP - A - 51 041 980**
**JP - A - 53 011 591**
**JP - A - 53 085 160**
**JP - B - 44 017 421**
**US - A - 3 946 334**
**US - A - 4 123 293**

(73) Proprietor: **FUJITSU LIMITED**
**1015, Kamikodanaka Nakahara-ku**
**Kawasaki-shi Kanagawa 211 (JP)**

(72) Inventor: **FUJIWARA, Kanji**
**Room 205 Wafuso 1041, Ohmaru**
**Inagi-shi, Tokyo 192-02 (JP)**

(74) Representative: **Muir, Ian R. et al,**
**HASELTINE LAKE & CO. Hazlitt House 28**
**Southampton Buildings Chancery Lane**
**London WC2A 1AT (GB)**

(56) References cited:
**REVIEW OF THE ELECTRICAL**
**COMMUNICATION LABORATORIES, vol. 25, no.**
**9-10, September-October 1977, Page 1052**
**Tokyo, JP. T. KADOTA et al.: "A study on film-**
**soldering of gold eutectic alloys" Page 1052,**
**paragraph 1; page 1053**
**LASER FOCUS, vol. 14, no. 3, March 1978,**
**pages 46-49 New York, U.S.A. LF staff roundup:**
**"Tailoring diodes to match fiber-system**
**requirements" Page 46, figure; page 48, figure**

Courier Press, Leamington Spa, England.

# Method of manufacturing semiconductor laser devices

This invention relates to a method of manufacturing a semiconductor laser device and, particularly, to a method of bonding a semiconductor laser element on to a heat sink.

Semiconductor laser elements from the gallium-arsenic (GaAs) family, gallium-aluminium-arsenic (GaAlAs) family or indium-gallium-arsenic-phosphor (InGaAsP) family, of compound semiconductor materials are currently being investigated and developed with a view to their practical application in optical communication systems.

For the practical application of said semiconductor laser elements in, for example, optical communication systems, the semiconductor laser element is required to have a high output power, long operation life and, furthermore, high reliability. In order to meet such requirements, it is essential to improve the electrical characteristics of the semiconductor laser element and at the same time provide efficient release of the Joule heat which is generated from the active layer of said semiconductor laser element which is being driven by a high current density.

As a means for improving the dispersion of heat, it has been proposed to use diamond (Type IIa diamond) having a thermal conductivity as high as about 5 times of that of copper at room temperature as a heat sink material, in place of the presently used metallic materials such as copper (Cu) or silver (Ag) etc.

In the case of mounting and bonding a semiconductor laser element on to such a heat sink consisting of diamond, it is required to mount and bond the semiconductor laser element without producing structural defects in it, whilst ensuring satisfactory thermal and electrical coupling between the heat sink and the semiconductor laser element.

The heat sink, consisting of diamond, facilitates bonding and support of a semiconductor laser element, with a metallized layer formed on its surface, and simultaneously provides one lead-out electrode for said semiconductor laser element.

Several methods following conventional technology have been proposed for mounting and bonding where a semiconductor laser element is mounted and bonded on a heat sink consisting of diamond (diamond heat sink) on the surface of which a metallized layer is formed.

(1) In a first proposed method, a gold (Au) layer is formed as the metallized layer on the surface of said diamond heat sink and a semiconductor laser element is bonded to said gold layer by indium (In) soldering.

Such a method was proposed because mechanical distortion generated when a semiconductor laser element is bonded to a heat sink has a large disadvantageous effect on the operating life of said semiconductor laser element and bonding by means of the indium solder allows little generation of such mechanical distortion.

(2) In a second proposed method, a tin (Sn) layer is formed on the surface of said diamond heat sink as the metallized layer and a gold layer is formed on the corresponding bonding surface of the semiconductor laser element whereafter the tin layer and the gold layer are placed in contact and heated, generating a gold-tin family eutectic crystalline alloy, thereby bonding the semiconductor laser element to the heat sink.

(3) In a third proposed method, a multiple-layer consisting of antimony (Sb)-, tin-, or indium-gold, or one of two layers of gold with a layer of tin, indium or antimony therebetween is formed on the surface of the diamond heat sink as the metallized layer, a multiple layer, chromium (Cr)-gold, is formed on the bonding surface of the semiconductor laser element, and thereafter both metallized layers are placed in contact and heated whilst pressed together, whereby a gold-antimony family eutectic crystalline alloy or gold-tin family eutectic crystalline alloy or gold-indium family eutectic crystalline alloy is formed such that the semiconductor laser element is bonded on to the heat sink.

However, with the bonding method (1) using indium solder, an aging variation of the bonding condition, particularly an increase of thermal resistance is marked so that, the laser drive current must be increased substantially in order to obtain the same laser beam output level. This has curtailed significantly the operating life of the laser elements in devices made by this method.

In method (2) where the gold layer is formed on the bonding surface of a semiconductor laser element, a tin layer is formed on the surface of a heat sink and both layers are placed in contact and heated, the tin layer surface becomes oxidized before being placed in contact with the gold and heated, so that sufficiently satisfactory thermal and mechanical coupling between the semiconductor laser element and the heat sink cannot be obtained.

Method (3) solves the problem existing in method (2). Since the metallized layer to be formed on the surface of the heat sink has a multi-layered structure of, for example, gold-tin-gold or tin-gold, where the tin (or antimony, indium) is not left exposed but is covered with the gold, the tin (or antimony, indium) is not oxidized prior to the semiconductor laser element and a heat sink being placed in contact and heated. However, this method (3) requires at least one additional process, that of forming the gold layer covering the tin (or antimony, indium), resulting in an increase in the manufacturing steps. Therefore, this method is less suitable for mass-production and is less economical. It is an object of the present invention to provide a method of manufacturing a semiconductor laser device wherein a semiconductor laser element can be mounted and bonded on a heat sink with a low thermal resistance value and rigid mechanical coupling property without the drawbacks of the previously proposed methods.

According to the present invention there is provided a method of manufacturing a semiconductor laser device in which a semiconductor laser element is heat-bonded to a heat sink wherein the surfaces of the element and heat sink to be bonded are each metallized prior to being brought together, and wherein bonding together is effected by bringing together and heating the metallized surfaces followed by cooling of the element and heat sink, characterized in that the heat sink metallization is formed by a gold alloy, that the heat sink with the metallization thereon is preheated to a temperature below the eutectic point of said gold alloy prior to being brought together with the element and in that, after being brought together, the heating is to a temperature higher than the eutectic point temperature of the gold alloy so as to melt the gold alloy layer and to fuse together this layer and the element metallization.

Since the metallized layer preliminarily formed on the surface of the heat sink is not easily oxidized and is structured by a single layer, bonding of the semiconductor laser element on said heat sink does not result in insufficient thermal and mechanical coupling or increase of manufacturing processes due to existence of oxide substance. Moreover, an aging variation of thermal resistance after bonding is very little and thereby improvement in operating life characteristics can be expected.

The gold alloy used in the present invention can be selected from the gold-tin family, the gold-antimony family, the gold-germanium family or the gold-silicon family alloys.

Several ways of carrying out the invention are described in detail below with reference to the accompanying drawings, in which:—

Figure 1 shows a perspective diagrammatic view of one example of an ordinary semiconductor laser element,

Figure 2 shows a cross section of one example of a semiconductor laser device accommodating the semiconductor laser element of Figure 1,

Figures 3 to 5 show cross-sectional views of part of the device of Figure 2 during stages in its manufacture,

Figures 6 to 8 show distributions of thermal resistances of a semiconductor laser device manufactured by the manufacturing method of the present invention and a semiconductor laser device manufactured by a prior proposed method,

Figure 9 shows aging variations of thermal resistance values of a semiconductor laser device manufactured by the manufacturing method of the present invention and a semiconductor laser device manufactured by said prior proposed method, and

Figure 10 shows aging variation of drive currents for a semiconductor laser device manufactured by the manufacturing method of the present invention and a semiconductor laser device manufactured by said prior proposed method.

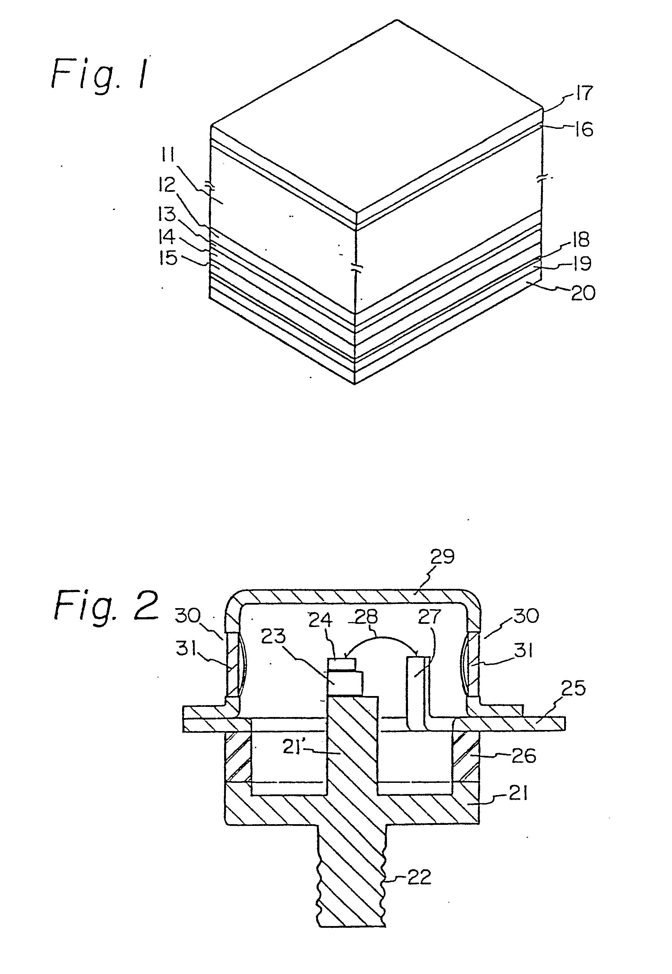

Figure 1 shows an example of a semiconductor laser element which may be used with the present invention.

In this figure, 11 is an N-type gallium-arsenide (GaAs) substrate; 12 is a clad layer consisting of N-type gallium-aluminium-arsenide ($Ga_{1-x}Al_xAs$) having a thickness of 1 ($\mu$m); 13 is an active layer consisting of P-type gallium-aluminium-arsenide ($Ga_{1-y}Al_yAs$) having a thickness of 0.1 ($\mu$m); 14 is a clad layer consisting of P-type gallium-aluminium-arsenide ($Ga_{1-x}Al_xAs$) having a thickness of 1 ($\mu$m); and 15 is an ohmic contact layer consisting of P-type gallium-arsenide (GaAs) having a thickness of 1 ($\mu$m).

For the formation of these semiconductor layers, the well-known liquid phase epitaxial growth method using said N-type gallium-arsenide 11 as a substrate can be adopted.

Additionally, the element has a gold (Au)-germanium(Ge)-nickel (Ni) alloy layer 16 of a thickness of 500 nm (5000 (Å)) and a gold layer 17 of a thickness of 1 ($\mu$m) covering said alloy layer 16. On the surface of P-type gallium-arsenide layer 15, a titanium (Ti) layer 18 of a thickness of 70 nm (700 (Å)) and a platinum (Pt) layer 19 of a thickness of 60 nm (600 (Å)) are formed, and finally a gold layer 20 of a thickness of 1 ($\mu$m) is formed thereon. These metallized layers are formed by the well-known vacuum evaporation or plating method.

A semiconductor laser element having such a structure has dimensions, for example, of 300 ($\mu$m) in length, 300 ($\mu$m) in width and 100 ($\mu$m) in thickness, and outputs a laser beam from the active layer 13 exposed at the cleavage plane when a forward current is applied across the electrodes 17 and 20.

It is also possible in order to define the laser beam emitting width on such active layer 13 for the P-type ohmic contact layer to be replaced by an N-type ohmic contact layer, for example, and for zinc (Zn) to be selectively diffused from the surface to the depth reaching the P-type clad layer 14, whereby the active layer adjacent to said zinc-diffused area is used as the laser beam emitting region.

A semiconductor laser element having such structure is, for example, accommodated into a case as shown in Figure 2 to form a semiconductor laser device.

In the Figure 2, 21 is a heat radiation stud which is composed of copper (Cu) and provided with a mounting screw 22 on its lower side (in the drawing); 23 is a diamond heat sink bonded on top of a projection 21' of said heat radiation stud 21; and 24 is a semiconductor laser element bonded on said heat sink 23. In addition, 25 is a flange consisting of, for example, a cover bonded onto the heat radiation stud 21 via a ceramic material 26; and 27 is a vertically erected part of said flange 25 which is connected with one electrode of said semiconductor laser element 24 by means of a lead wire 28. A sealing cap 29 is welded to said flange 25 by a resistance welding method in order to hermetically seal the semiconductor laser element 24 and this cap is provided with a window 30 for the laser beam generated by the semiconductor laser element, the window being sealed by sapphire 31.

The present invention offers an improved method for bonding the semiconductor laser element 24 onto heat sink 23 which is also bonded onto the heat radiation stud 21.

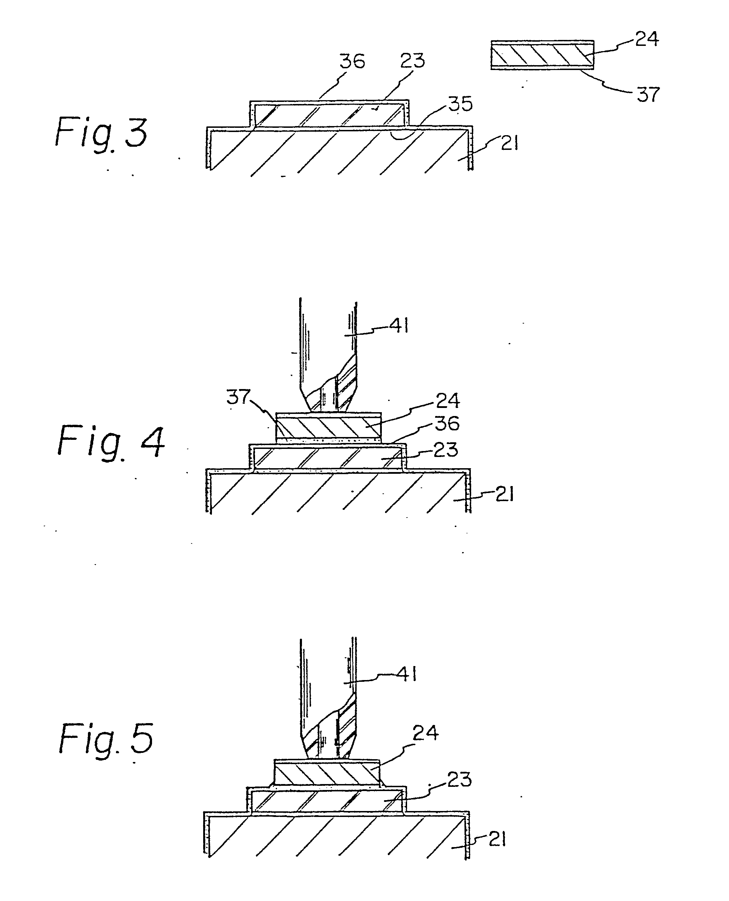

Figures 3 to 5 show stages in a method of manufacturing a semiconductor laser device in accordance with the present invention. In Figures 3 to 5, those parts which are the same as those of Figure 2 are given the same numbers as in Figure 2.

Embodiment 1

In this embodiment, a gold (Au)-tin (Sn) alloy is used as the bonding material for bonding a semiconductor laser element 24 on the heat sink 23.

First of all, a diamond heat sink with dimensions of, for example, 0.7 (mm) in length, 0.7 (mm) in width and 0.4 (mm) in height with the formation of a chromium (Cr) layer and a platinum (Pt) layer on its surface is bonded on top of the heat radiation stud 21 by means of the bonding materials 35 consisting of gold-silicon (Si). Then, the gold-tin alloy layer 36 is formed by the vacuum evaporation method to a thickness of 2 ($\mu$m) on the surface of the heat sink 23. At the same time, the alloy layer is also formed on the surface of the heat radiation stud 21 adjacent to the surface of the heat sink 23.

As the material for use in the vacuum evaporation of gold-tin alloy, the gold-tin vacuum evaporation alloy material (including 20% by weight of tin) which can be obtained on the market is used.

A gold metallizing layer 37 (or 20 in Figure 1) is formed separately, through a vacuum evaporating method or a combination of a vacuum evaporation method and a plating method, to a thickness of 1 ($\mu$m), for example, on the bonding surface of a semiconductor laser element 24 which is to be bonded to the heat sink.

Then, the heat radiation stud 21 is fixed onto the hot plate of the heater (not illustrated) by a vacuum suction method, and the stud 21 and the heat sink 23 bonded thereon are preliminarily heated up to 200 (°C) by applying a current to the resistance material provided in said hot plate.

A semiconductor laser element 24 held by suction to the vacuum tool or collet 41 is then placed on the gold-tin alloy layer 36 on the surface of the heat sink 23 and is pressed thereon using said vacuum collet 41. While, holding this condition, the hot plate is further heated to produce initially a temperature rise of about 12 (°C/sec), and thereby the heat radiation stud 21, heat sink 23 and semiconductor laser element 24 are heated up to beyond the eutectic point temperature (280°C) of the gold-tin alloy layer; up to a temperature of 400 (°C) in this embodiment.

When the temperature exceeds the eutectic point temperature, the gold-tin alloy fuses.

In this embodiment, when, during the heating, the heating temperature reaches a temperature near the eutectic point temperature of the gold-tin alloy layer, the vacuum collet 41 is vibrated ultrasonically so as to promote fusing and alloy-metallization of the gold-tin layer and the time for heating the layer from the eutectic point temperature to the maximum temperature of 400 (°C) is specified as 8 seconds. The application of such ultrasonic wave vibration is very effective in reducing the time taken for the manufacturing processes. When the temperature reaches 400 (°C), this temperature is maintained for several seconds and heating is suspended. Then the device is cooled to room temperature.

By this process, the semiconductor laser element 24 is bonded onto the heat sink 23 as shown in Figure 5.

Thereafter, the vacuum collet 41 is removed, and the assembled unit formed by the heat radiation stud 21, heat sink 23 and semiconductor laser element 24 is removed from the heater.

The other electrode (the fold layer 17 in said Figure 1) of the semiconductor laser element 24 and the external lead-out terminal formed by the vertically extending part 27 in Figure 2 are connected with a lead wire such as a gold wire (the lead wire 28 in Figure 2) by the ordinary method.

Then, a metal sealing cap 29 (Figure 2) is prepared and arranged on the heat radiation stud covering said semiconductor laser element, whereafter the semiconductor laser element is hermetically sealed by welding said metal cap and flange (flange 25 in Figure 2) into an integrated form in a nitrogen gas atmosphere.

Embodiment 2

In this embodiment the manufacturing method follows that used in embodiment 1 except that during the heating process no ultrasonic wave vibration is applied, and the time period from the eutectic point temperature to the start of cooling is specified as 60 seconds.

Even with such a process without ultrasonic vibration, a bonding condition which is effectively the same as that obtained in embodiment 1 can be achieved.

Embodiment 3

In this embodiment, a gold (Au)-germanium (Ge) alloy is used as the gold alloy metallization on the heat sink 23 for bonding the semiconductor laser element 24 on to the heat sink.

First, a diamond heat sink 23 with dimensions of, for example, 0.7 (mm) in width, 0.7 (mm) in length, and 0.4 (mm) in height, having a chromium (Cr) layer and platinum (Pt) layer formed on its surface is bonded on top of the heat radiation stud 21 using the bonding material 35 consisting of gold-silicon (Si). Then, the gold-germanium alloy metallization layer 36 is formed by a vacuum evaporation method to a thickness of 2 ($\mu$m) on the surface of said heat sink. At the same time, the alloy layer 36 is also formed on the adjacent surface of heat sink 23.

As the vacuum evaporation material there is used the gold-germanium vacuum evaporation alloy material including 12% (by weight of germanium) which can be obtained on the market.

A gold metallizing layer 37 (20 in Figure 1) is formed separately by the vacuum evaporation method or by the combination of a vacuum evaporation method and a plating method on the bonding surface of the semiconductor laser element 24 as shown in Figure 1 to the desired thickness, for example, of 1 ($\mu$m).

Then, the heat radiation stud 21 is fixed onto the hot plate of a heater (not illustrated) by a vacuum suction method, and the stud 21 and the heat sink 23 bonded thereon are preheated to a temperature of 200 (°C) by supplying a current to the resistance material provided in said hot plate.

A semiconductor laser element 24, held by suction to the vacuum tool or collet 41 (as shown in Figure 4), is placed on the gold-germanium alloy layer 36 on the surface of the heat sink 23 and is pressed thereon by the vacuum collet 41. While holding this condition, the temperature of said hot plate is increased initially at a temperature rise rate of about 12 (°C/sec) and thereby the heat sink 23 and semiconductor laser element 24 are heated up to a temperature higher than the eutectic point temperature 356 (°C) of the gold-germanium alloy layer, namely up to 420 (°C) in the case of this embodiment. When the temperature exceeds the eutectic point temperature, the gold-germanium alloy fuses.

In this embodiment, when the heating temperature reaches a temperature near the eutectic point temperature of the gold-germanium alloy layer during the heating process, the vacuum collet 41 is ultrasonically vibrated in order to promote fusing and alloy metallization of the gold-germanium, and the time period for heating from the eutectic point temperature to 420 (°C) is specified as 10 seconds. The application of such ultrasonic wave vibration is very effective in reducing the time of the manufacturing processes. When the heating temperature reaches 420 (°C), this temperature is maintained for several seconds, heating is suspended and then the fused layer is cooled to a room temperature.

Thereby the semiconductor laser element 24 is bonded onto the heat sink 23 as shown in Figure 5.

Thereafter, the relevant semiconductor laser element is hermetically sealed as in embodiment 1.

In the described manufacturing methods of the present invention, the heat radiation stud 21 fixed on the hot plate and the heat sink bonded on said heat radiation stud 21 are heated up to a temperature 30 to 250 (°C), preferably 100 to 250 (°C) prior to bonding of a semiconductor laser element. Such preliminary heating of the heat radiation stud and heat sink is very useful in the manufacturing process because the period of bonding of a semiconductor laser element can be reduced.

The rate of temperature rise, when the temperature is raised from such preheating condition to a temperature higher than the eutectic point of the gold alloy layer for heating said heat sink and a semiconductor laser element pressed thereon is selected within the range from 0.2 to 100 (°C/sec) or more desirably within the range from 1 to 50 (°C/sec). When the rate of temperature rise is under 0.2 (°C/sec), a long time heating process is required. This would cause reduction of laser beam output level due to contamination or oxidation of the cleavage plane of a semiconductor laser element or increase of thermal resistance resulting from insufficient contact due to contamination or oxidation of the gold alloy layer surface. If a rate of temperature rise exceeds 100 (°C/sec), a thermal impact is generated due to a difference of thermal expansion coefficients between the compound semiconductor and the electrode metals forming a semiconductor laser element which causes deterioration of the semiconductor laser element.

In addition, the maximum heating temperature reached in the period from fusing of the gold alloy layer to the start of cooling is selected from the range of 300 to 450 (°C) or desirably from within the range 350 to 430 (°C). If such a maximum heating temperature is under 300 (°C), the gold alloy layer does not sufficiently unite with the electrode metal in the semiconductor laser element and a so-called insufficient wetting condition occurs, resulting in increase of thermal resistance. If the maximum temperature exceeds 450 (°C), the electrode metal of the semiconductor laser element is deteriorated and the cleavage plane is contaminated or oxidized, causing deterioration of said semiconductor laser element.

Moreover, the time period from fusing of said gold alloy layer to start of cooling is selected

**0 019 003**

from the range of 5 sec to 5 minutes, or desirably from the range 5 sec to 3 minutes. In order to obtain sufficiently good contact of the heat sink with the semiconductor laser element, sufficient, bonding is required of the gold alloy layer of the heat sink surface with the metallized layer in a semiconductor laser element. When an ultrasonic wave vibration is applied as in the case of embodiment 1, the time period can be reduced to 5 to 15 seconds. Moreover, when said maximum heating temperature is about 300 (°C), the desirable period from fusing of the gold alloy layer to the start of cooling is selected to be about 5 minutes.

Comparison of thermal resistance and operating life characteristic (aging variation of drive current) between semiconductor laser devices manufactured by means of the present invention and manufactured by using the previously proposed indium solder method gave the following results.

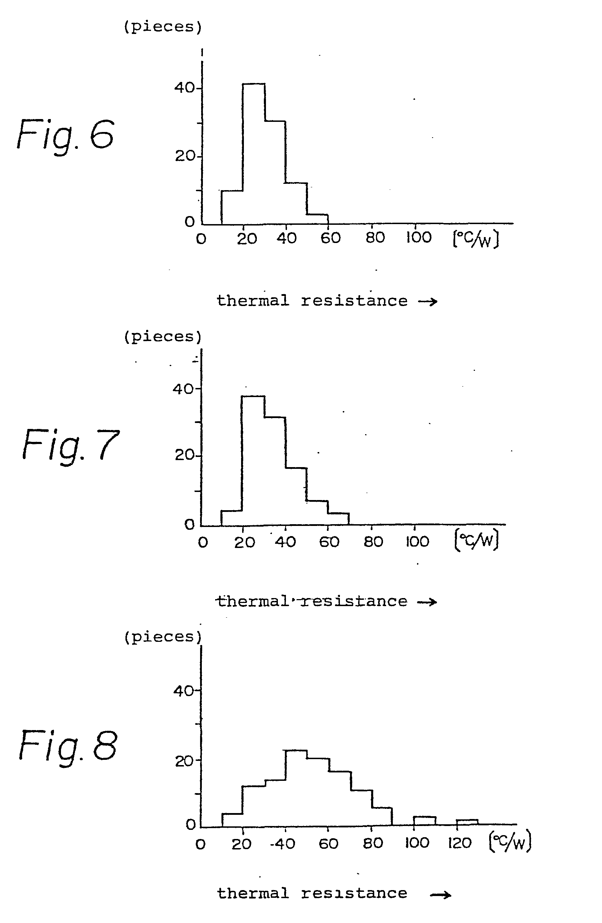

The distribution of thermal resistance, of 100 semiconductor laser elements each of which is bonded on a diamond heat sink by the method of embodiment 1 of the present invention using the gold-tin alloy, of 100 semiconductor laser elements each of which is bonded on a diamond heat sink by the method of embodiment 3 of the present invention using the gold-germanium alloy, and of 100 semiconductor laser elements each of which is bonded on a diamond heat sink using indium solder, are shown respectively in Figures 6 to 8.

In Figure 6, the gold-tin alloy method of the present invention is used. In Figure 7, the gold-germanium alloy of the present invention is used. In Figure 8, indium solder is used in accordance with the existing proposed method. The thickness of the indium solder is 3 ($\mu$m) in the step where it is coated on a heat sink.

As is obvious from these results, when a gold alloy layer is applied to a manufacturing method of the present invention, the thermal resistance is kept low and is distributed over a lower range as compared with that obtained when indium solder is used.

Here, a thermal resistance is defined as the value obtained by dividing the deviation ($\Delta\lambda$), of wave lengths at the peak value of optical intensity of naturally emitted light generated when a pulse input is applied to a semiconductor laser element and at the peak value of optical intensity of light generated when a DC voltage having the same current as said pulse input is applied to it, by the temperature coefficient of the wave length of emitted light previously obtained from the semiconductor material and the DC input power.

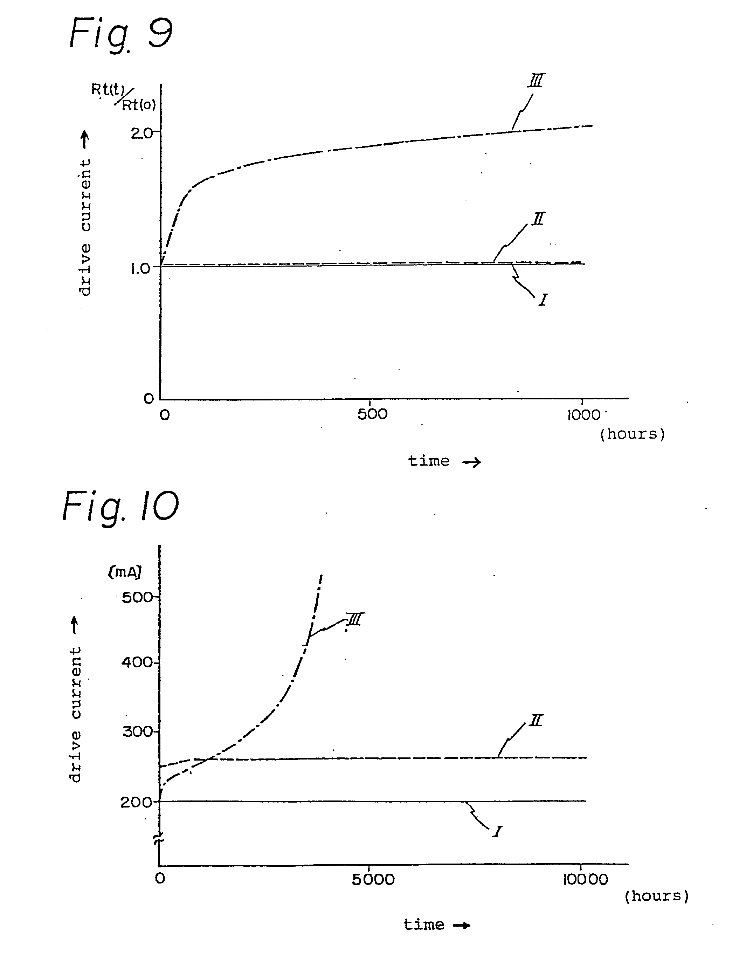

When a semiconductor laser device manufactured by the afore-mentioned method is put into operation at a specified output per single end of semiconductor laser element of 5 (mW) at an ambient temperature of 70 (°C), the aging variation of thermal resistance of said bonding material and aging variation of drive current of the relevant semiconductor laser devices are shown respectively in Figure 9 and Figure 10.

Figure 9 shows the aging variation of thermal resistance (ratio of thermal resistance $R_t(t)$ after the specified period to the initial value $R_t(O)$; $R_t(t)/R_t(O)$). Figure 10 shows aging variation of drive current. In both figures, the curve I indicates the characteristics for devices, wherein the gold-tin alloy is used for bonding, whilst the curve II is for gold-germanium alloy devices, and the curve III is for indium solder devices.

As is obvious from these results, when such a gold alloy layer is used for the manufacturing method of the present invention, the thermal resistance values change little even after 1000 hours and drive current values change only 5 (%) or less even after 10000 hours. On the other hand, when the indium solder is used, both thermal resistance and drive current show substantial changes as much as 2 times the initial values even after a relatively short period of operation.

Twenty semiconductor laser devices where the semiconductor laser element was bonded onto a diamond heat sink with gold-tin alloy by the above-mentioned method, and another twenty semiconductor laser devices where the semiconductor laser element was bonded with indium solder were put into operation for 2000 hours at the specified output per single end of the semiconductor laser element of 5 (mW) at the above-mentioned ambient temperature of 70 (°C), and the number of good elements was investigated.

As a result, 19 elements of those using the gold-tin alloy layer remained good, whilst only eight elements of those using the indium solder remained good.

As is clear from the above results, a semiconductor laser device formed by the manufacturing method of the present invention has lower thermal resistance of the bonding material for bonding a semiconductor laser element onto a heat sink and relatively no aging variation of it. As a result, the aging variation of drive current is very little and thereby its operating life characteristic can be improved significantly.

A difference of effect is very obvious even when it is compared with the existing bonding method using the indium solder. Moreover, it is obvious from the results shown in Figure 9 and Figure 10 that the bonding material in the manufacturing method of the present invention does not disadvantageously interfere with the operating life characteristic of the semiconductor laser element by giving it a mechanical distortion.

Even when compared with the existingly proposed bonding method where, for example, the gold layer is formed on the bonding surface of a semiconductor laser element and a multi-layered metallized layer is formed on the surface of the heat sink, the method of the present invention has a large effect in such a point that manufacturing processes can be reduced and an operating life characteristic of a semiconductor laser device is much improved due to lower thermal resistance of bonding material and no aging variation of it.

In above embodiments of this invention, a diamond heat sink is used, but this invention can also be adopted to the case where such heat sink is composed of copper or silver material from the economical viewpoint.

## Claims

1. A method of manufacturing a semiconductor laser device in which a semiconductor laser element is heat-bonded to a heat sink wherein the surfaces of the element and heat sink to be bonded are each metallized prior to being brought together, and wherein bonding together is effected by bringing together and heating the metallized surfaces followed by cooling of the element and heat sink, characterized in that the heat sink metallization is formed by a gold alloy, that the heat sink with the metallization thereon is preheated to a temperature below the eutectic point of said gold alloy prior to being brought together with the element and in that, after being brought together, the heating is at a temperature higher than the eutectic point temperature of the gold alloy so as to melt the gold alloy layer and to fuse together this layer and the element metallization.

2. A method of manufacturing a semiconductor laser device as claimed in claim 1, characterized in that the gold alloy selected is one of the alloys of gold-tin, gold-germanium, gold-antimony or gold-silicon.

3. A method of manufacturing a semiconductor laser device as claimed in claim 1 or 2, characterized in that the preheating temperature of the heat sink is selected from the range of 30 to 250 (°C).

4. A method of manufacturing a semiconductor laser device as claimed in any one of claims 1 to 3, characterized in that the rate of temperature rise in the heating of the brought-together element and heat sink to a temperature higher than the eutectic point temperature is selected from the range of 0.2 to 100 (°C/sec).

5. A method of manufacturing a semiconductor laser device as claimed in any one of claims 1 to 4, characterized in that the temperature attained during the fusing stage is selected from the temperature range of 300 to 450 (°C).

6. A method of manufacturing a semiconductor laser device as claimed in any one of claims 1 to 5, characterized in that the period from melting of the gold alloy layer and start of cooling is selected from the range of times of 5 seconds to 5 minutes.

7. A method of manufacturing a semiconductor laser device as claimed in any preceding claim, characterized in that the semiconductor laser element is ultrasonically vibrated when the heating temperature reaches a temperature near the eutectic point temperature of the gold alloy layer.

## Patentansprüche

1. Verfahren zur Herstellung von Halbleiter-Laservorrichtungen, bei welchem ein Halbleiterelement durch Wärme mit einer Wärmesenke verbunden wird, wobei die zu verbindenden Oberflächen des Elements und der Wärmesenke, bevor sie zusammengebracht werden, jeweils metallisiert werden und wobei die Verbindung bewirkt wird, in dem die beiden metallisierten Oberflächen zusammengebracht und erwärmt und anschließend das Element und die Wärmesenke gekühlt werden, dadurch gekennzeichnet, daß die Metallisierung der Wärmesenke durch eine Goldlegierung gebildet wird, daß die Wärmesenke mit der darauf befindlichen Metallisierung auf eine Temperatur unterhalb des eutektischen Punktes der genannten Goldlegierung vorerwärmt wird, bevor sie mit dem Element zusammengebracht wird, und daß, nachdem sie zusammengebracht worden sind, die Erwärmung bei einer Temperatur oberhalb des eutektischen Temperaturpunktes der Goldlegierung durchgeführt wird, um die Goldlegierungsschicht zu schmelzen und diese Schicht und die Elementmetallisierung miteinander zu verschmelzen.

2. Verfahren zur Herstellung von Halbleiter-Laservorrichtungen nach Anspruch 1, dadurch gekennzeichnet, daß die Goldlegierung eine der Legierungen Gold-Zinn, Gold-Germanium, Gold-Antimon oder Gold-Silizium ist.

3. Verfahren zur Herstellung von Halbleiter-Laservorrichtungen nach Anspruch 1 oder 2, dadurch gekennzeichnet, daß die Vorwärmungstemperatur der Wärmesenke im Bereich zwischen 30 und 250 (°C) gewählt ist.

4. Verfahren zur Herstellung von Halbleiter-Laservorrichtungen nach einem der Ansprüche 1 bis 3, dadurch gekennzeichnet, daß die Rate des Temperaturanstiegs beim Erwärmen des Elements und der Wärmesenke nach dem Zusammenbringen derselben auf eine Temperatur oberhalb des eutektischen Temperaturpunktes im Bereich von 0,2 bis 100 (°C/Sekunde) gewählt ist.

5. Verfahren zur Herstellung von Halbleiter-Laservorrichtungen nach einem der Ansprüche 1 bis 4, dadurch gekennzeichnet, daß die während der Verschmelzungsstufe erreichte Temperatur im Bereich zwischen 300 und 450 (°C) gewählt ist.

6. Verfahren zur Herstellung von Halbleiter-Laservorrichtungen nach einem der Ansprüche 1 bis 5, dadurch gekennzeichnet, daß die Periode vom Schmelzen der Goldlegierungsschicht und dem Beginn der Kühlung im Bereich zwischen 5 Sekunden bis 5 Minuten gewählt ist.

7. Verfahren zur Herstellung von Halbleiter-

**0 019 003**

Laservorrichtungen nach einem der vorhergehenden Ansprüche, dadurch gekennzeichnet, daß das Halbleiter-Laserelement durch Ultraschall fibriert wird, wenn die Erwärmungstemperatur eine Temperatur nahe dem eutektischen Temperaturpunkt der Goldlegierungsschicht erreicht.

## Revendications

1. Un procédé de fabrication d'un dispositif laser semiconducteur dans lequel un élément laser semiconducteur est fixé de façon thermique sur un radiateur, dans lequel les surfaces de l'élément et du radiateur à fixer sont métallisées avant d'être amenées l'une contre l'autre, et dans lequel la fixation s'effectue en amenant l'une contre l'autre et en chauffant les surfaces métallisées, après quoi l'élément et le radiateur sont refroidis, caractérisé en ce qu'on forme la métallisation du radiateur par un alliage d'or, en ce qu'on préchauffe le radiateur portant la métallisation, jusqu'à une température inférieure au point d'eutexie de l'alliage d'or, avant de l'amener contre l'élément et en ce que, une fois que la radiateur et l'élément ont été amenès l'un contre l'autre, on effectue le chauffage jusqu'à une température supérieure à la température du point d'eutexie de l'alliage d'or, afin de faire fondre la couche d'alliage d'or et de fusionner cette couche avec la métallisation de l'élément.

2. Un procédé de fabrication d'un dispositif laser semiconducteur selon la revendication 1, caractérisé en ce que l'alliage d'or choisi est l'un des alliages suivants: or-étain, or-germanium, or-antimoine ou or-silicium.

3. Un procédé de fabrication d'un dispositif laser semiconducteur selon la revendication 1 ou 2, caractérisé en ce que la température de préchauffage du radiateur est choisie dans la plage de 30 à 250°C.

4. Un procédé de fabrication d'un dispositif laser semiconducteur selon l'une quelconque des revendications 1 à 3, caractérisé en ce que la vitesse d'élévation de la température dans le chauffage de l'élément et du radiateur amenés l'un contre l'autre, jusqu'à une température supérieure à la température du point d'eutexie, est choisie dans la plage de 0,2 à 100°C/s.

5. Un procédé de fabrication d'un dispositif laser semiconducteur selon l'une quelconque des revendications 1 à 4, caractérisé en ce que la température atteinte pendant la phase de fusion est choisie dans la plage de température de 300 à 450°C.

6. Un procédé de fabrication d'un dispositif laser semiconducteur selon l'une quelconque des revendications 1 à 5, caractérisé en ce que la durée allant de la fusion de la couche d'alliage d'or jusqu'au début du refroidissement est choisie dans la plage de durées de 5 secondes à 5 minutes.

7. Un procédé de fabrication d'un dispositif laser semiconducteur selon n'importe quelle revendication précédente, caractérisé en ce qu'on fait vibrer par ultrasons l'élément laser semiconducteur lorsque la température de chauffage atteint une température voisine de la température du point d'eutexie de la couche d'alliage d'or.

0 019 003

Fig. 1

Fig. 2

1

Fig. 3

Fig. 4

Fig. 5

*Fig. 6*

(pieces)

thermal resistance →

*Fig. 7*

(pieces)

thermal resistance →

*Fig. 8*

(pieces)

thermal resistance →

*Fig. 9*

*Fig. 10*